# EUROPEAN PATENT APPLICATION

(11) **EP 4 270 450 A1**
(43) Date of publication of application: **01.11.2023**
(21) Application number: 22742516.2
(22) Date of filing: 14.01.2022
(51) Int. Cl.: H01L 21/304, H01L 21/66

(54) **METHOD FOR EVALUATING WORK-MODIFIED LAYER, AND METHOD OF MANUFACTURING SEMICONDUCTOR SINGLE CRYSTAL SUBSTRATE**

(30) Priority: 19.01.2021 JP 2021006736
(71) Applicant: Kwansei Gakuin Educational Foundation, Nishinomiya-shi, Hyogo 662-8501 (JP); YGK Corporation, Alps-shi, Yamanashi 400-0311 (JP); Toyota Tsusho Corporation, Nagoya-shi Aichi 450-8575 (JP)
(72) Inventor: KANEKO, Tadaaki, Sanda-shi, Hyogo (JP); Nakura, Yoshinobu, Alps-shi, Yamanashi 400-0311 (JP); Asakawa, Kazunobu, Alps-shi, Yamanashi 400-0311 (JP); KOJIMA, Kiyoshi, Tokyo 108-8208 (JP)
(74) Representative: dompatent von Kreisler Selting Werner - Partnerschaft von Patent- und Rechtsanwälten mbB
(86) International application number: PCT/JP2022/001180
(87) International publication number: WO 2022/158394

(57) **Abstract**

An object of the present invention is to provide a novel technique capable of evaluating a subsurface damaged layer without destroying a semiconductor single crystal. As means for solving this object, the present invention causing a laser light to be incident from a surface of a semiconductor single crystal substrate to evaluate the subsurface damaged layer of the semiconductor single crystal substrate based on an intensity of a scattered light which is scattered inside the semiconductor single crystal substrate.

## Description

### Technical Field

The present invention relates to a method of evaluating a subsurface damaged layer and a method of manufacturing a semiconductor single crystal substrate.

### Background Art

In general, a semiconductor single crystal substrate (so-called wafer) is formed by slicing an ingot of a semiconductor material and grinding/polishing the surface thereof. On the surface of the semiconductor single crystal substrate, there is formed a surface layer (hereinafter referred to as a subsurface damaged layer) having crystal strain, scratches, or the like introduced at the time of slicing or grinding/polishing. It is preferable to remove the subsurface damaged layer because the subsurface damaged layer causes a decrease in device yield in a device manufacturing step.

Conventionally, destructive inspection has been generally used as a method of evaluating the presence or absence and the degree of the subsurface damaged layer. For example, in the case of silicon carbide (SiC), which is a compound semiconductor material classified as a material that is extremely difficult to process, the subsurface damaged layer of a semiconductor single crystal substrate made of silicon carbide (SiC) is evaluated by observing a cross section obtained by cleaving the semiconductor single crystal substrate using an electron back scattered diffraction pattern (EBSD) method of a transmission electron microscope (TEM) or a scanning electron microscope (SEM) (see Patent Literature 1).

### Citation List

### Patent Literature

Patent Literature 1: JP 2020-017627 A

### Summary of Invention

### Technical Problem

As described above, in the conventional evaluation of the subsurface damaged layer, destructive inspection of cleaving the semiconductor single crystal substrate has been the mainstream. Therefore, there is a problem that the semiconductor single crystal substrate for which the subsurface damaged layer is evaluated cannot be returned to the device manufacturing step.

In addition, various studies have been made on the use of Raman spectroscopy for evaluation of subsurface damaged layer of semiconductor single crystal substrate. On the other hand, since it is necessary to measure Raman scattering which is weaker than elastic scattering such as Rayleigh scattering in Raman spectroscopy, it takes time to evaluate the entire surface of one semiconductor single crystal substrate. Therefore, there has been a problem that the throughput is lowered when Raman spectroscopy is introduced into a manufacturing step of semiconductor single crystal substrate.

In view of the above problem, the problem to be solved by the present invention is to provide a novel technique capable of evaluating a subsurface damaged layer without destroying a semiconductor single crystal substrate.

Another problem to be solved by the present invention is to provide a novel technique capable of mapping the distribution of a subsurface damaged layer at high speed without destroying a semiconductor single crystal substrate.

### Solution to Problem

In order to solve the above-mentioned problem, the present invention provides a method of evaluating a subsurface damaged layer, the method causing a laser light to be incident from a surface of a semiconductor single crystal substrate to evaluate a subsurface damaged layer of the semiconductor single crystal substrate based on the intensity of a scattered light which is scattered inside the semiconductor single crystal substrate.

In a preferred mode of the present invention, the evaluation method includes a measurement step of measuring the intensity of a scattered light which is scattered by causing a laser light to enter the semiconductor single crystal substrate and an evaluation step of evaluating the subsurface damaged layer based on the intensity of the scattered light.

In a preferred mode of the present invention, the evaluation step includes an area setting step of setting a plurality of arbitrary areas obtained by dividing the semiconductor single crystal substrate into arbitrary sizes and a statistic calculation step of calculating a statistic of the intensity of the scattered light for each of the arbitrary areas.

In a preferred mode of the present invention, the statistic calculation step includes an integration step of integrating the intensities of the scattered light in the arbitrary areas and a division step of dividing an integrated value obtained in the integration step by the number of acquired data in the arbitrary areas.

In a preferred mode of the present invention, the evaluation step includes a threshold setting step of setting the threshold for determining the quality of the subsurface damaged layer and a mapping step of mapping the arbitrary areas where the statistic exceeds the threshold.

In a preferred mode of the present invention, the measurement step is a step of scanning the semiconductor single crystal substrate with the laser light while rotating the semiconductor single crystal substrate.

In a preferred mode of the present invention, the measurement step is a step of measuring the scattered light including elastic scattering.

In a preferred mode of the present invention, the measurement step is a step of causing the laser light to be incident at an incident angle of inclination with respect to a normal line of a surface of the semiconductor single crystal substrate.

In a preferred mode of the present invention, the laser light is at a wavelength having a photon energy greater than the band gap of the semiconductor single crystal substrate.

In a preferred mode of the present invention, the evaluation method includes a cleaning step of cleaning the surface of the semiconductor single crystal substrate.

In a preferred mode of the present invention, the semiconductor single crystal substrate is a compound semiconductor single crystal substrate.

The present invention also relates to a method of manufacturing a semiconductor device. That is, in order to solve the above-mentioned problem, the present invention provides a method of manufacturing a semiconductor single crystal substrate, the method including: a measurement step of measuring the intensity of a scattered light which is scattered inside a semiconductor single crystal substrate by causing a laser light to be incident from a surface of the semiconductor single crystal substrate; and an evaluation step of evaluating the subsurface damaged layer of the semiconductor single crystal substrate based on the intensity of the scattered light.

In a preferred mode of the present invention, a subsurface damaged layer removal step is performed to remove the subsurface damaged layer of the semiconductor single crystal substrate after the evaluation step.

In a preferred mode of the present invention, the subsurface damaged layer removal step is chemical mechanical polishing.

In a preferred mode of the present invention, the subsurface damaged layer removal step is etching.

In a preferred mode of the present invention, the semiconductor single crystal substrate is a compound semiconductor.

### Advantageous Effects of Invention

According to the disclosed technique, it is possible to provide a novel technique capable of evaluating a subsurface damaged layer without destroying a semiconductor single crystal substrate.

Further, according to the disclosed technique, it is possible to provide a novel technique capable of mapping the distribution of a subsurface damaged layer at high speed without destroying a semiconductor single crystal substrate.

Other problems, features and advantages will become apparent upon reading Description of Embodiments to be described below when taken together with the drawings and claims.

### Brief Description of Drawings

Fig. 1 is an explanatory diagram illustrating a method of evaluating a subsurface damaged layer according to an embodiment.
Fig. 2 is a block diagram of an evaluation apparatus used in the evaluation method according to the embodiment.
Fig. 3 is an explanatory diagram of a measurement step of the evaluation method according to the embodiment.
Fig. 4 is an explanatory diagram of an evaluation step of the evaluation method according to the embodiment.
Fig. 5 is an explanatory diagram illustrating an evaluation result of an example.

### Description of Embodiments

Preferred embodiments of a method of evaluating a subsurface damaged layer and a method of manufacturing a semiconductor single crystal substrate according to the present invention will be described in detail below with reference to the accompanying drawings. The technical scope of the present invention is not limited to the embodiments illustrated in the accompanying drawings, and may be appropriately changed within the scope recited in the claims. In the following description of the embodiments and the accompanying drawings, the same components are denoted by the same reference signs, and redundant description thereof is omitted.

### <<Method of Evaluating Subsurface Damaged Layer>>

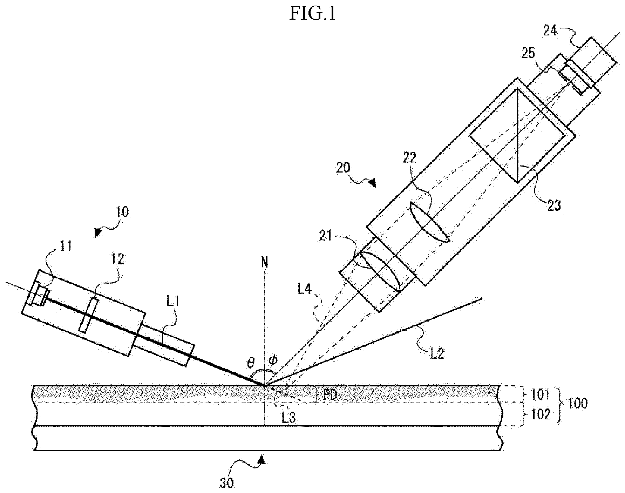

Fig. 1 is an explanatory diagram illustrating a method of evaluating a subsurface damaged layer according to an embodiment.

The method of evaluating a subsurface damaged layer according to the present invention is characterized in that a subsurface damaged layer 101 is evaluated based on the intensity of a scattered light L4 scattered by the subsurface damaged layer 101. Specifically, a laser light L1 irradiated from a light projecting system 10 is incident from a surface of a semiconductor single crystal substrate 100 to the inside of the semiconductor single crystal substrate 100. An incident light L3 which enters the semiconductor single crystal substrate 100 is scattered by the subsurface damaged layer 101 to generate the scattered light L4. The scattered light L4 is measured by a light receiving system 20, and the subsurface damaged layer 101 is evaluated based on the intensity of the scattered light L4.

The semiconductor single crystal substrate 100 is a semiconductor material manufactured by steps including at least one of a slicing step, a polishing step, and a grinding step. As the semiconductor single crystal substrate 100 manufactured through these steps, a silicon (Si) substrate can be exemplified. In the slicing step, the polishing step, and the grinding step described above, the subsurface damaged layer 101 that has an adverse effect on device manufacturing may be introduced. In particular, recent studies have revealed that the subsurface damaged layer 101 has an adverse effect on a device made of a compound semiconductor material classified as a material that is difficult to process. The present invention is suitable for evaluating the subsurface damaged layer 101 of a compound semiconductor material substrate such as a SiC substrate, a GaN substrate, an AlN substrate, a Ga₂O₃ substrate, or a sapphire substrate.

The method of evaluating a subsurface damaged layer according to the embodiment may include a cleaning step S10 of cleaning the surface of the semiconductor single crystal substrate 100, a measurement step S20 of measuring the intensity of the scattered light L4 scattered by causing the laser light L1 to be incident on the subsurface damaged layer 101 of the semiconductor single crystal substrate 100, and an evaluation step S30 of evaluating the subsurface damaged layer 101 based on the intensity of the scattered light L4.

Hereinafter, each step will be described in detail according to the embodiment of the present invention.

### <Cleaning Step S10>

The cleaning step S10 is a step of eliminating the causes of scattering of the laser light L1 on the surface of the semiconductor single crystal substrate 100 due to organic contamination, particle contamination, oxidized layer, ion contamination, or the like attached to the surface of the semiconductor single crystal substrate 100. In particular, when particles adhere to the surface of the semiconductor single crystal substrate 100, a scattering stronger than that of the scattered light L4 generated in the subsurface damaged layer 101 occurs. Therefore, it is desirable that particle contamination or the like is removed before the subsurface damaged layer 101 is measured.

As a method of the cleaning step S10, any method may be employed as long as it can remove at least one of organic contamination, particle contamination, oxidized layer, and ion contamination attached to the surface of the semiconductor single crystal substrate 100. For example, chemical cleaning such as general RCA-cleaning (NH₄OH, H₂O₂, H₂O) or acid cleaning (HCl, HF), or physical cleaning using bubbles, brushes, etc. may be employed.

The cleaning step S10 according to the embodiment has been described above. Note that the method of evaluating a subsurface damaged layer according to the present invention may also be exemplified by an embodiment that does not include the cleaning step S10. That is, when the surface of the semiconductor single crystal substrate 100 is sufficiently clean, the measurement step S20 and the evaluation step S30 to be described later may be included.

### <Measurement Step S20>

As shown in Fig. 1, the measurement step S20 is a step in which the incident light L3, which is irradiated with the light projecting system 10 of the evaluation apparatus and is incident from the surface of the semiconductor single crystal substrate 100, is scattered inside the subsurface damaged layer 101, and the scattered light L4 which is scattered thereby is measured by the light receiving system 20. The measurement step S20 according to the present embodiment is a step of causing the laser light L1 to be incident at an incident angle θ of inclination with respect to a normal line N of the surface of the semiconductor single crystal substrate 100.

A part of the laser light L1, which is irradiated from the light projecting system 10 at the incident angle θ in this manner, is regularly reflected on the surface of the semiconductor single crystal substrate 100 as a reflection light L2, and another part of the laser light L1 enters the semiconductor single crystal substrate 100 as the incident light L3. Further, the incident light L3 is scattered by the subsurface damaged layer 101 to generate the scattered light L4.

The reflection light L2 is regularly reflected at the same angle as the incident angle θ of the laser light L1 and has a higher intensity than the scattered light L4. The present invention is a method of evaluating the subsurface damaged layer 101 based on the intensity of the scattered light L4. Thus, in order to accurately measure the scattered light L4, it is necessary to suppress the reflection light L2 from entering a light receiving sensor 24. For example, it is possible to employ a method of disposing the light receiving system 20 so as to avoid the reflection light L2 or a method of limiting light entering the light receiving sensor 24 by disposing a light shielding tape on the optical path of the reflection light L2, etc.

The scattered light L4 measured in the present invention includes elastic scattering. That is, by including elastic scattering having a higher intensity than that of inelastic scattering in the scattered light L4 to be measured, the sensitivity of measurement can be improved, and high-speed measurement can be realized.

The evaluation apparatus used for evaluating subsurface damaged layer according to the embodiment can naturally be employed as long as it has an apparatus configuration capable of measuring the intensity of the scattered light L4 which is scattered by the subsurface damaged layer 101 through causing the laser light L1 to be incident on the semiconductor single crystal substrate 100.

An example of the evaluation apparatus used in the embodiment will be described below with reference to Figs. 1 to 3.

### (Evaluation Apparatus)

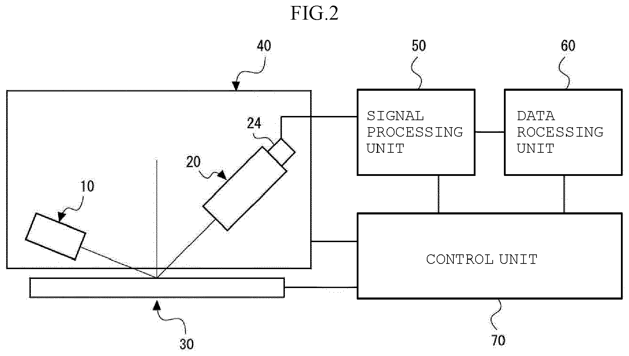

Fig. 2 is a block diagram of an evaluation apparatus used in the evaluation method according to the embodiment.

The evaluation apparatus includes the light projecting system 10 for irradiating the laser light L1, the light receiving system 20 for receiving the scattered light L4, a stage 30 on which the semiconductor single crystal substrate 100 to be measured is arranged, a housing 40 in which the light projecting system 10 and the light receiving system 20 are arranged, a signal processing unit 50 for processing signals measured by the light receiving system 20, a data processing unit 60 for processing data, and a control unit 70 for performing control.

The light projecting system 10 includes a laser output unit 11 and a wavelength plate 12. The light projecting system 10 is attached to the housing 40 in a manner that the laser light L1 is incident at the incident angle θ of inclination with respect to the normal line N of the surface of the semiconductor single crystal substrate 100.

The laser output unit 11 is a generation source of the laser light L1, and for example, a gas laser such as a He-Ne laser, a solid-state laser such as a semi-conductor laser or a YAG laser, or the like may be employed.

The wavelength plate 12 performs adjustments such as separation of wavelengths, fine adjustment, adjustment of ellipticity, and rotation of polarized light on the laser light L1 generated by the laser output unit 11. The appropriate material and structure are selected according to the material and conditions of the semiconductor single crystal substrate 100 to be measured.

It is preferable that the wavelength of the laser light L1 has a photonic energy greater than the band gap of the semiconductor single crystal substrate 100. In other words, it is preferable that a wavelength λ of the laser light L1 satisfies a relational expression "λ [nm] ≤ 1239.8/band gap [eV]".

Specifically, when the object to be measured is 4H-SiC, it is preferable to set the wavelength to be equal to or shorter than 380 nm (λ [nm] ≤ 1239.8/3.26 [eV]). When the object to be measured is GaN, it is preferable to set the wavelength to be equal to or shorter than 365 nm (λ [nm] ≤ 1239.8/3.39 [eV]).

It is preferable that the intensity of the laser light L1 is set to such an intensity that the laser light L1 does not pass through the semiconductor single crystal substrate 100. That is, it is preferable that a penetration length PD of the incident light L3 is set to be equal to or less than the thickness of the semiconductor single crystal substrate 100.

The light receiving system 20 includes an objective lens 21, an imaging lens 22, a beam splitter 23, the light receiving sensor 24, and a slit 25. The light receiving system 20 is attached to the housing 40 at a measurement angle ϕ different from the incident angle θ in a manner that the reflection light L2 does not enter the light receiving system 20.

It is preferable to employ a cube-type beam splitter as the beam splitter 23. The light receiving sensor 24 may have a configuration capable of converting the intensity of the scattered light L4 into an electric signal. For example, a photomultiplier tube, a photodiode, or the like may be employed. The slit 25 is arranged to define an inspection area of the laser light L1.

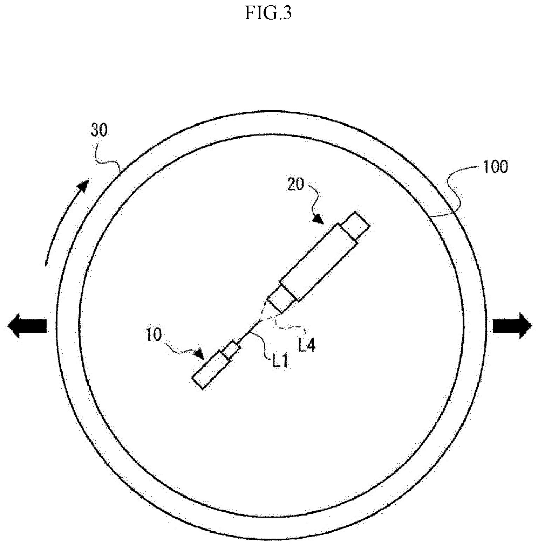

Fig. 3 is an explanatory diagram of the measurement step S20 of the evaluation method according to the embodiment.

As shown in Fig. 3, the stage 30 is provided with the semiconductor single crystal substrate 100 to be measured, and is configured to be horizontally rotatable about the center of the semiconductor single crystal substrate 100. In addition, the stage 30 is configured such that the semiconductor single crystal substrate 100 can be moved in parallel with respect to the housing 40 (the light projecting system 10 and the light receiving system 20). Thus, the laser light L1 can scan a wide range (or the entire surface) of the semiconductor single crystal substrate 100 by moving the semiconductor single crystal substrate 100 in parallel while rotating the semiconductor single crystal substrate 100.

Although the stage 30 is moved in this embodiment, the housing 40 may be moved so that the laser light L1 can scan over the semiconductor single crystal substrate 100.

The signal processing unit 50 amplifies an electric signal (analog signal) measured by the light receiving sensor 24 (photomultiplier tube) and then converts the electric signal into a digital signal. In addition, the signal processing unit 50 acquires position information from encoder information of the stage 30, and associates intensity information of the scattered light L4 with the position information.

The data processing unit 60 performs data processing based on the data from the signal processing unit 50 to classify the scattered light L4 according to its intensity and create a distribution map of the subsurface damaged layer 101. In addition, the control unit 70 controls irradiation and scanning of the laser light.

The data processing unit 60 and the control unit 70, for example, employ a hardware configuration such as a processor and a storage, and are configured to include the light projecting system 10, the light receiving system 20, the stage 30, and the signal processing unit 50 and to be capable of communicating with each other via a local area network or the like.

In the measurement step S20 according to the present embodiment, the laser light L1 is incident at the incident angle θ of inclination with respect to the normal line N of the surface of the semiconductor single crystal substrate 100, but it is naturally possible to employ a configuration in which the laser light L1 is incident parallel to the normal line N (i.e., incident at the incident angle θ = 0°) to generate the scattered light L4.

### <Evaluation Step S30>

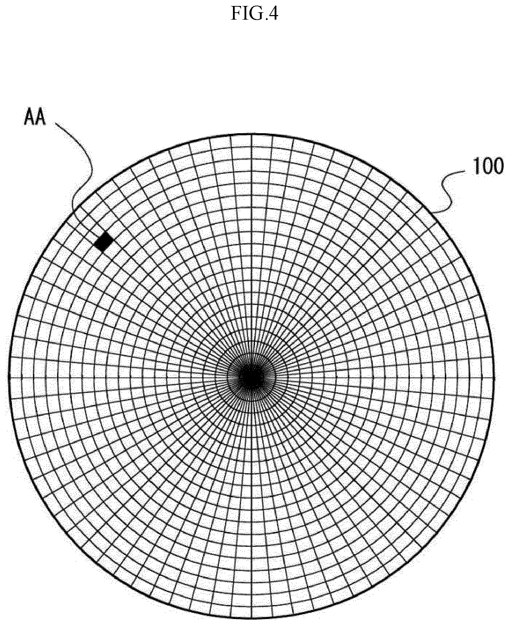

Fig. 4 is an explanatory diagram of the evaluation step S30 of the evaluation method according to the embodiment.

The evaluation step S30 is a step of evaluating the quality of the subsurface damaged layer 101 of the semiconductor single crystal substrate 100 based on the data obtained in the measurement step S20. Particularly, in the evaluation step S30, arbitrary areas AA are set on the semiconductor single crystal substrate 100, and the subsurface damaged layer 101 is evaluated based on the intensity of the scattered light L4 for each of the arbitrary areas AA, thereby mapping a region where a defective subsurface damaged layer 101 exists in the semiconductor single crystal substrate 100.

The evaluation step S30 may include an area setting step S31 of setting the arbitrary areas AA obtained by dividing the semiconductor single crystal substrate 100 into arbitrary sizes, a statistic calculation step S32 of calculating a statistic of the intensity of the scattered light L4 for each of the arbitrary areas AA, a threshold setting step S33 of setting the threshold for determining the quality of the subsurface damaged layer 101, and a mapping step S34 of mapping the arbitrary areas AA where the statistic exceeds the threshold.

The area setting step S31 is a step of setting the arbitrary areas AA by dividing the measurement data measured in the measurement step S20 into a plurality of sections. In Fig. 4, the fan-shaped arbitrary areas AA are set on concentric circles, but the arbitrary areas AA may be set in arbitrary shapes and sizes such as a lattice shape or a spiral shape.

The statistic calculation step S32 is a step of calculating a statistic such as a mean value, a median value, or a mode for each of the set arbitrary areas AA. For example, when the mean value is employed as the statistic, the statistic calculation step S32 includes an integration step S321 of integrating the intensities of the scattered light L4 in the arbitrary areas AA, and a division step S322 of dividing the integrated value obtained in the integration step S321 by the number of acquired data in the arbitrary areas of the arbitrary areas AA.

The integration step S321 is a step of calculating the integrated value of the scattered light L4 in the set arbitrary areas AA based on the intensity information and the position information of the scattered light L4 associated by the signal processing unit 50.

The division step S322 is a step of dividing the integrated value obtained in the integration step S321 by the number of acquired data in the arbitrary areas of the arbitrary areas AA to obtain the mean value in the range of the set arbitrary areas AA.

The threshold setting step S33 is a step of setting the threshold for extracting an inappropriate subsurface damaged layer 101 that has an adverse effect on device manufacturing. Note that a plurality of thresholds may be set.

The mapping step S34 is a step of creating a distribution map visualizing the distribution state of the subsurface damaged layer 101. For example, regions in which the value of the statistic of the arbitrary areas AA is higher than the set threshold are displayed in black, and portions in which the value of the statistic of the arbitrary areas AA is lower than the threshold are displayed in white. Thus, by displaying the arbitrary areas AA in color or in contrast on the distribution map, it is possible to visually distinguish a region in which a suitable subsurface damaged layer 101 is distributed from a region in which an unsuitable subsurface damaged layer 101 is distributed. When a plurality of thresholds are set, a distribution map having a plurality of colors or multilevel contrasts may be created.

In other words, the evaluation step S30 is a step of evaluating regions where the statistic is smaller than the threshold as suitable regions and evaluating regions where the statistic is larger than the threshold as unsuitable regions.

Note that the evaluation step S30 according to the embodiment may be configured to cause a processor of a computer to execute the area setting step S31, the statistic calculation step S32, the threshold setting step S33, and the mapping step S34.

According to the method of evaluating a subsurface damaged layer of the present invention, the subsurface damaged layer 101 can be evaluated in a non-destructive manner by causing the laser light L1 to be incident from the surface of the semiconductor single crystal substrate 100 and measuring the scattered light L4 generated by scattering the incident light L3 inside the subsurface damaged layer 101. Therefore, the semiconductor single crystal substrate 100 having the subsurface damaged layer 101 that adversely affects a device can be distinguished without being destroyed, and can be sent to a device manufacturing step after being subjected to an appropriate process such as removal of the subsurface damaged layer 101.

In addition, according to the method of evaluating a subsurface damaged layer of the present invention, measurement sensitivity can be improved by measuring the scattered light L4 including elastic scattering. That is, most of the scattered light L4 generated by scattering inside the subsurface damaged layer 101 is elastic scattering. The present invention improves measurement sensitivity by measuring the scattered light L4 in a manner of including the elastic scattering.

According to the method of evaluating a subsurface damaged layer of the present invention, the subsurface damaged layer 101 may be mapped at high speed by scanning the semiconductor single crystal substrate 100 with the laser light L1 while rotating the semiconductor single crystal substrate 100. Specifically, in the case of a 6-inch semiconductor single crystal substrate 100, the entire surface may be mapped within 5 minutes per substrate.

Further, according to the method of evaluating a subsurface damaged layer of the present embodiment, by setting the arbitrary areas AA (the area setting step S31) and calculating the statistic of the arbitrary areas AA (the statistic calculation step S32), the entire subsurface damaged layer 101 existing in a wide range of the semiconductor single crystal substrate 100 may be evaluated. That is, the subsurface damaged layer 101 may be visualized and evaluated by integrating and utilizing all the measurement data instead of selecting a part of the measurement data.

### <<Method of Manufacturing Semiconductor Single Crystal Substrate>>

Next, a method of manufacturing a semiconductor single crystal substrate according to the present invention will be described in detail. Note that, in the following embodiment, components that are basically the same as those in the previous embodiment of "Method of Evaluating Subsurface Damaged Layer" are denoted by the same reference signs, and the description thereof is simplified.

The method of manufacturing a semiconductor single crystal substrate according to the present invention includes a step of evaluating the subsurface damaged layer 101 which adversely affects a device. Specifically, the method includes a step of causing the laser light L1 to enter the semiconductor single crystal substrate 100 and evaluating the subsurface damaged layer 101 of the semiconductor single crystal substrate 100 based on the intensity of the scattered light L4.

In general, when a semiconductor single crystal substrate is manufactured, the method includes a slicing step of slicing an ingot to cut out a wafer, and a grinding step and a polishing step for mirror-finishing the wafer thereafter. Along with the slicing, grinding, and polishing, the subsurface damaged layer 101 is introduced into the semiconductor single crystal substrate 100. The present invention evaluates the subsurface damaged layer 101 described above, and may be employed after the slicing step. The present invention may also be employed after the grinding step. The present invention may also be employed after the polishing step.

The method of manufacturing a semiconductor single crystal substrate according to the embodiment may include the measurement step S20 of measuring the scattered light L4 scattered inside the semiconductor single crystal substrate 100 by causing the laser light L1 to be incident from the surface of the semiconductor single crystal substrate 100, and the evaluation step S30 of evaluating the subsurface damaged layer 101 of the semiconductor single crystal substrate 100 based on the intensity of the scattered light L4.

The method of manufacturing a semiconductor single crystal substrate according to the embodiment may include a subsurface damaged layer removal step S40 of removing the subsurface damaged layer 101 of the semiconductor single crystal substrate 100 after the evaluation step S30.

Hereinafter, each step will be described in detail according to the embodiment of the present invention. Since the measurement step S20 and the evaluation step S30 are the same as those in "Method of Evaluating Subsurface Damaged Layer" described above, the description thereof is simplified.

### <Subsurface Damaged Layer Removal Step S40>

The subsurface damaged layer removal step S40 is a step of removing the subsurface damaged layer 101 determined to be unsuitable in the evaluation step S30. Chemical mechanical polishing (CMP) or an etching method can be exemplified as the method of removing the subsurface damaged layer 101.

Chemical mechanical polishing is a technique for polishing by using a mechanical action of a polishing pad and a chemical action of slurry in combination.

The etching method may be a method used for etching the semiconductor single crystal substrate 100. For example, when the semiconductor single crystal substrate material is SiC, a thermal etching method such as a SiVE method or a hydrogen etching method, or a wet etching method using a potassium hydroxide molten solution, a chemical solution containing hydrofluoric acid, a potassium permanganate chemical solution, a chemical solution containing tetramethylammonium hydroxide, or the like, can be exemplified. Any chemical solution normally used in wet etching can be employed.

By the method of manufacturing a semiconductor single crystal substrate according to the present invention, the semiconductor single crystal substrate 100 suitable for manufacturing a device can be provided. That is, it is possible to distinguish and provide the semiconductor single crystal substrate 100 which does not have the subsurface damaged layer 101 which deteriorates device yield. As a result, device yield can be improved.

Further, by the method of manufacturing a semiconductor single crystal substrate according to the present embodiment, it is possible to reuse the semiconductor single crystal substrate 100 having the subsurface damaged layer 101 which reduces device yield. That is, since the subsurface damaged layer 101 of the semiconductor single crystal substrate 100 can be evaluated in a non-destructive manner, the semiconductor single crystal substrate 100 suitable for manufacturing a device can be manufactured through the subsurface damaged layer removal step S40 for removing the subsurface damaged layer 101 which is seen as a problem.

### Examples

Hereinafter, the present invention will be described in more detail with reference to examples.

The subsurface damaged layer 101 of the 6-inch 4H-SiC wafer after chemical mechanical polishing is evaluated using the evaluation apparatus shown in the embodiment of the present invention.

### <Cleaning Step S10>

The 6-inch 4H-SiC wafer, which has been subjected to chemical mechanical polishing, is subjected to RCA cleaning.

### <Measurement Step S20>

The 4H-SiC wafer subjected to the cleaning step S10 is measured using the evaluation apparatus shown in Figs. 1 and 2. As shown in Fig. 3, by moving the 4H-SiC wafer arranged on the stage 30 in the X-axis direction while rotating the 4H-SiC wafer, the laser light L1 is used to scan the entire surface of the semiconductor single crystal substrate 100, and the scattered light L4 including elastic scattering is measured. Note that the measurement is performed under the conditions that the measurement region is ϕ144 mm and the wavelength of the laser light L1 is 355 nm. The measurement time required for one 6-inch 4H-SiC wafer is 3 minutes.

### <Evaluation Step S30>

As shown in Fig. 4, the fan-shaped arbitrary areas AA are set radially from the center of the semiconductor single crystal substrate 100 (the area setting step S31). Next, the intensities of the scattered light L4 in the range corresponding to the positions of the set arbitrary areas AA are integrated (the integration step S321). Next, the integrated value is divided by the number of acquired data of the arbitrary areas AA to calculate a mean value for each of the arbitrary areas AA (the division step S322). Finally, a plurality of thresholds are set (the threshold setting step S33), and a distribution map, in which the mean values of the arbitrary areas AA are classified into regions where the mean values are higher and regions where the mean values are lower than the set thresholds, is created to visualize the suitability/unsuitability of the subsurface damaged layer 101 of the semiconductor single crystal substrate 100 (the mapping step S34).

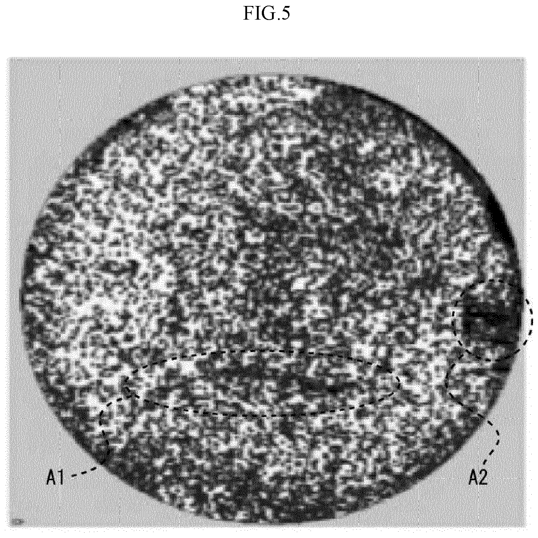

Fig. 5 is a distribution map of the subsurface damaged layer 101 obtained in the evaluation step S30.

Note that, in this embodiment, 8 thresholds including an arbitrary unit 50, an arbitrary unit 100, an arbitrary unit 110, an arbitrary unit 130, an arbitrary unit 150, an arbitrary unit 200, an arbitrary unit 400, and an arbitrary unit 800 are set. Specifically, the distribution map is created in a manner that areas with mean value that is equal to or less than the arbitrary unit 50 are white, areas with mean value in a range from the arbitrary unit 50 to the arbitrary unit 100 are dark blue, areas with mean value in a range from the arbitrary unit 100 to the arbitrary unit 110 are dark green, areas with mean value in a range from the arbitrary unit 110 to the arbitrary unit 130 are yellow green, areas with mean value in a range from the arbitrary unit 130 to the arbitrary unit 150 are yellow, areas with mean value in a range from the arbitrary unit 150 to the arbitrary unit 200 are orange, areas with mean value in a range from the arbitrary unit 200 to the arbitrary unit 400 are red, areas with mean value in a range from the arbitrary unit 400 to the arbitrary unit 800 are purple, and areas with mean value that is equal to or greater than the arbitrary unit 800 are black.

Note that the arbitrary units are obtained by converting the intensities of the scattered light L4 captured by the light receiving system 20 into voltages, and are units proportional to the intensities of the scattered light L4 which are set arbitrarily. That is, the arbitrary units may be any unit as long as each of the arbitrary areas can be relatively compared.

As can be seen from the distribution map of Fig. 5, a black region A1 like a scratch running in the lateral direction can be confirmed at a lower central portion of the substrate. In addition, a black region A2 appearing in a square shape at a right portion of the substrate can be confirmed. By confirming the distribution map in this way, it can be grasped that the region where black appears has the subsurface damaged layer 101 which adversely affects device manufacturing.

The subsurface damaged layer in the example is evaluated in a non-destructive manner. Therefore, the evaluated 4H-SiC wafer can be sent to a device manufacturing step without being discarded.

### Reference Signs List

- 100: Semiconductor single crystal substrate
- 101: Subsurface damaged layer
- 102: Bulk layer
- 10: Light projecting system
- 11: Laser output unit
- 12: Wavelength plate
- 20: Light receiving system
- 21: Objective lens
- 22: Imaging lens
- 23: Beam splitter
- 24: Light receiving sensor
- 25: Slit
- 30: Stage
- 40: Housing
- 50: Signal processing unit
- 60: Data processing unit
- 70: Control unit
- L1: Laser light
- L2: Reflection light
- L3: Incident light
- L4: Scattered light
- PD: Penetration depth
- AA: Arbitrary area
- S10: Cleaning step
- S20: Measurement step
- S30: Evaluation step
- S40: Subsurface damaged layer removal step

## Claims

1. A method of evaluating a subsurface damaged layer, the method causing a laser light to be incident from a surface of a semiconductor single crystal substrate to evaluate the subsurface damaged layer of the semiconductor single crystal substrate based on an intensity of a scattered light which is scattered inside the semiconductor single crystal substrate.

2. The method of evaluating a subsurface damaged layer according to claim 1, comprising:
a measurement step of measuring an intensity of a scattered light which is scattered by causing a laser light to enter the semiconductor single crystal substrate; and
an evaluation step of evaluating the subsurface damaged layer based on the intensity of the scattered light.

3. The method of evaluating a subsurface damaged layer according to claim 2, wherein
the evaluation step includes
an area setting step of setting a plurality of arbitrary areas obtained by dividing the semiconductor single crystal substrate into arbitrary sizes and
a statistic calculation step of calculating a statistic of the intensity of the scattered light for each of the arbitrary areas.

4. The method of evaluating a subsurface damaged layer according to claim 3, wherein
the statistic calculation step includes
an integration step of integrating the intensity of the scattered light in the arbitrary areas and
a division step of dividing an integrated value obtained in the integration step by a number of acquired data in the arbitrary areas.

5. The method of evaluating a subsurface damaged layer according to claim 3 or claim 4, wherein
the evaluation step includes
a threshold setting step of setting a threshold for determining a quality of the subsurface damaged layer and
a mapping step of mapping the arbitrary areas where the statistic exceeds the threshold.

6. The method of evaluating a subsurface damaged layer according to any one of claims 2 to 5, wherein the measurement step is a step of scanning the semiconductor single crystal substrate with the laser light while rotating the semiconductor single crystal substrate.

7. The method of evaluating a subsurface damaged layer according to any one of claims 2 to 6, wherein the measurement step is a step of measuring the scattered light including elastic scattering.

8. The method of evaluating a subsurface damaged layer according to any one of claims 2 to 7, wherein the measurement step is a step of causing the laser light to be incident at an incident angle of inclination with respect to a normal line of a surface of the semiconductor single crystal substrate.

9. The method of evaluating a subsurface damaged layer according to any one of claims 1 to 8, wherein the laser light is at a wavelength having a photon energy greater than a band gap of the semiconductor single crystal substrate.

10. The method of evaluating a subsurface damaged layer according to any one of claims 2 to 9, further comprising a cleaning step of cleaning the surface of the semiconductor single crystal substrate.

11. The method of evaluating a subsurface damaged layer according to any one of claims 1 to 10, wherein the semiconductor single crystal substrate is a compound semiconductor single crystal substrate.

12. A method of manufacturing a semiconductor single crystal substrate, the method comprising:
a measurement step of measuring an intensity of a scattered light which is scattered inside a semiconductor single crystal substrate by causing a laser light to be incident from a surface of the semiconductor single crystal substrate; and
an evaluation step of evaluating a subsurface damaged layer of the semiconductor single crystal substrate based on the intensity of the scattered light.

13. The method of manufacturing a semiconductor single crystal substrate according to claim 12, wherein a subsurface damaged layer removal step is performed to remove the subsurface damaged layer after the evaluation step.

14. The method of manufacturing a semiconductor single crystal substrate according to claim 13, wherein the subsurface damaged layer removal step is chemical mechanical polishing.

15. The method of manufacturing a semiconductor single crystal substrate according to claim 13, wherein the subsurface damaged layer removal step is etching.

16. The method of manufacturing a semiconductor single crystal substrate according to any one of claims 12 to 15, wherein the semiconductor single crystal substrate is a compound semiconductor.
